# EUROPEAN PATENT APPLICATION

(11) **EP 1 241 707 A2**
(43) Date of publication of application: **18.09.2002**
(21) Application number: 02005550.5
(22) Date of filing: 11.03.2002
(51) Int. Cl.: H01L 21/762

(54) **SOI substrate, annealing method therefor, semiconductor device having the SOI substrate, and method of manufacturing the same**

(30) Priority: 12.03.2001 JP 2001068745
(71) Applicant: CANON KABUSHIKI KAISHA, Ohta-ku, Tokyo (JP)
(72) Inventor: Ito, Masataka, Ohta-ku, Tokyo (JP)
(74) Representative: Leson, Thomas Johannes Alois, Dipl.-Ing.

(57) **Abstract**

This invention relates to a method of manufacturing an SOI wafer having a low HF defect density using annealing in a reducing atmosphere. An SOI substrate is annealed in a reducing atmosphere at a temperature lower than the melting point of single-crystal silicon. To prevent any HF defects, a holding tool having a surface formed from silicon is used as a holding tool for holding the SOI substrate.

## Description

### FIELD OF THE INVENTION

The present invention relates to an SOI (Semiconductor On Insulator) substrate and an annealing method for the SOI substrate and, more particularly, to a high-quality SOI substrate and annealing method therefor, which reduce the number of HF defects in an SOI layer caused by annealing. The term "SOI" is used to indicate "Silicon On Insulator" or "Semiconductor On Insulator". In the present application, this term is used to indicate the latter, i.e., "Semiconductor On Insulator".

### BACKGROUND OF THE INVENTION

A technique for obtaining a flat surface by annealing an SOI substrate in a reducing atmosphere is disclosed in, e.g., Japanese Patent Laid-Open No. 05-217821. The reducing atmosphere is explicitly mentioned in the prior art as "an atmosphere containing, e.g., hydrogen or a hydrogen atmosphere".

According to this prior art, by annealing in a hydrogen gas at, e.g., 1,000°C, a high planarity is obtained while suppressing the roughness of an SOI layer surface observed with an atomic force microscope to 2 nm or less. As a characteristic feature of surface planarization by hydrogen annealing, no physical damage occurs on the surface, unlike a method using polishing.

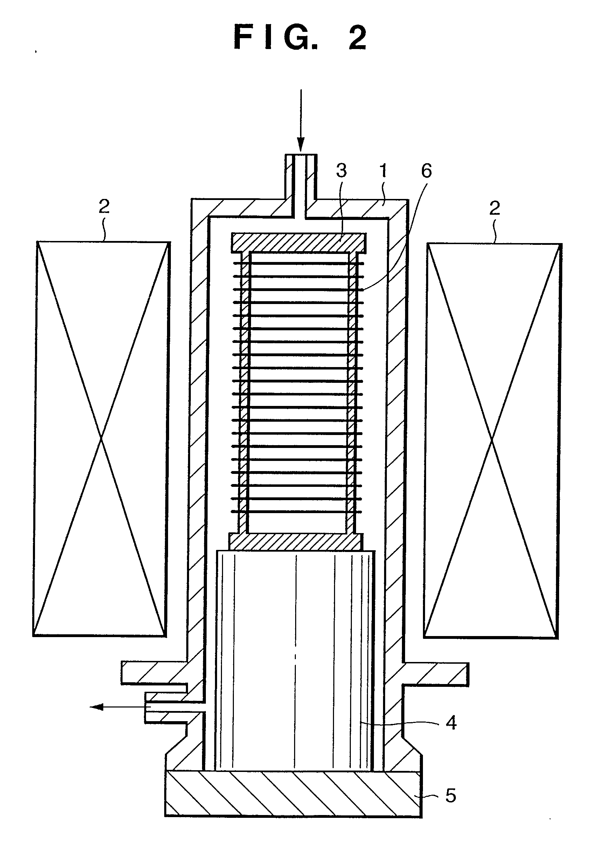

A prior art will be described with reference to Fig. 2. An SOI wafer is used as a form of an SOI substrate. A furnace tube 1 forms an annealing chamber. An atmospheric gas is introduced from an introduction tube arranged on the upper side and exhausted from an exhaust tube on the lower side. A boat 3 made of silicon carbide is mounted on a heat barrier 4 arranged on a furnace lid 5 and holds a plurality of SOI wafers 6. For the boat 3, silicon carbide prepared by sintering is used. In some cases, a chemically synthesized silicon carbide coating film is formed by CVD (Chemical Vapor Deposition) on a surface of silicon carbide prepared by sintering.

In the prior art, when an SOI wafer is subjected to high-temperature annealing in a reducing atmosphere, the number of defects called HF defects in an SOI layer sometimes increases. An HF defect is described in Sadana et al., "NANO-DEFECTS IN COMMERCIAL BONDED SOI AND SIMOX", Proceedings 1994 IEEE International SOI Conference, Oct. 1994. This defect unique to an SOI wafer is produced when an SOI wafer is dipped in hydrofluoric acid (HF). Sadana et al. suggest that HF defects are caused by metal contamination and pinholes in the SOI layer. These defects probably cause an operation error of a device formed on the SOI wafer. A decrease in defect density is being demanded.

A related technique is disclosed in Japanese Patent Laid-Open No. 5-152230, "A silicon wafer annealing method characterized by placing a silicon wafer on a silicon boat and annealing it in a reducing gas atmosphere at 1,000°C to 1,300°C". However, this technique is quite different from the technical idea of the present invention because the prior art is related to control of oxidation induced stacked defects in a silicon wafer and "has as its object to provide an annealing method capable of preventing any wafer fall accident during annealing or any local wafer etching".

Japanese Patent Laid-Open No. 5-152230 has neither description about an SOI wafer or defects in an SOI wafer nor description about metal contamination in a wafer. This prior art does not suggest that the number of HF defects in a wafer is decreased by combining the technique with an SOI wafer.

### SUMMARY OF THE INVENTION

The present invention has been made in consideration of the above situation, and has as its object to provide an SOI wafer for which the HF defect density is reduced by using annealing in a reducing atmosphere, an annealing method for the SOI wafer, a semiconductor device having the SOI wafer, and a method of manufacturing the same.

In order to achieve the above object, according to an aspect of the present invention, there is provided an annealing method of annealing an SOI substrate in a reducing atmosphere at a predetermined temperature, and more preferably, at a temperature lower than the melting point of single-crystal silicon, comprising the step of holding the SOI substrate by a holding portion having a surface formed from silicon and annealing the SOI substrate.

According to another aspect of the present invention, there is provided an annealing method of annealing an SOI substrate in a reducing atmosphere at a predetermined temperature, and more preferably, at a temperature lower than the melting point of single-crystal silicon, comprising the step of holding the SOI substrate by a holding portion which contains no silicon carbide formed by sintering and has a surface formed from silicon carbide deposited by CVD and annealing the SOI substrate.

According to the preferred aspect of the present invention annealing is preferably executed at a temperature not less than 775°C, preferably a temperature not less than 966°C, or more preferably a temperature not less than 993°C.

An SOI substrate of the present invention is manufactured using the above annealing method and preferably has an HF defect density not more than 0.05 pieces/cm².

According to the present invention, there is also provided a semiconductor device manufacturing method, comprising the step of forming an active region for a transistor in a nonporous semiconductor layer of the SOI substrate. The transistor may be a partially depleted thin-film MOS transistor or a fully depleted thin-film MOS transistor.

The present inventors extensively studied HF defects which increase when an SOI wafer was annealed in a reducing atmosphere at a high temperature and found that the increase in number of HF defects was associated with extremely light metal contamination caused in the SOI wafer by annealing. Especially, when annealing is executed in a reducing atmosphere, metal contamination of nickel or the like occurs on the wafer surface, although the amount of contamination is very small. This forms a fine deposit (e.g., nickel silicide) as a compound of silicon and a metal. The present inventors are convinced that such a deposit is one of causes for HF defects in the SOI wafer.

The present inventors found that one of metal contamination sources was a boat formed by impregnating silicon carbide prepared by sintering with molten silicon. The present inventors also found that even when a boat made of silicon carbide and having a surface coated with chemically synthesized silicon carbide purer than sintered silicon carbide was used, similar metal contamination occurred as the coating film degraded. On the basis of these findings, the present invention solves the problems by the above means.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a sectional view of an apparatus according to an embodiment of the present invention;
Fig. 2 is a sectional view of an apparatus according to a prior art;
Fig. 3 is a longitudinal sectional view of a boat for holding wafers;
Fig. 4 is a sectional view taken along a line C - C; and
Figs. 5A to 5D are sectional views of a semiconductor device formed using a semiconductor wafer according to the embodiment of the present invention.

### DETAILED DESCRIPTION OF THE PREFERRED EMBODIMENTS

As a typical method of preparing silicon carbide by CVD, a gas containing, e.g., silicon atoms is chemically reacted with a gas containing carbon atoms whereby silicon carbide (SiC) is deposited on a surface of an object to be processed to form a thin film. As a typical method of preparing silicon carbide by sintering, silicon carbide powder is mixed with a binder to make a clay-like material, and it is molded and sintered at a high temperature.

As described above, in the present application, the term "SOI" is used to indicate "Semiconductor On Insulator".

A typical reducing atmosphere is an atmosphere containing, e.g., hydrogen or a hydrogen atmosphere.

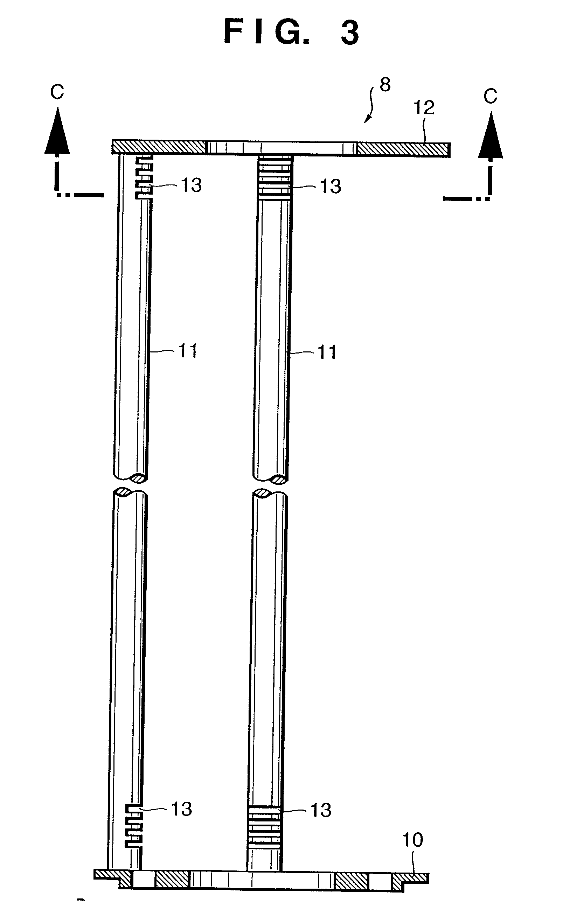

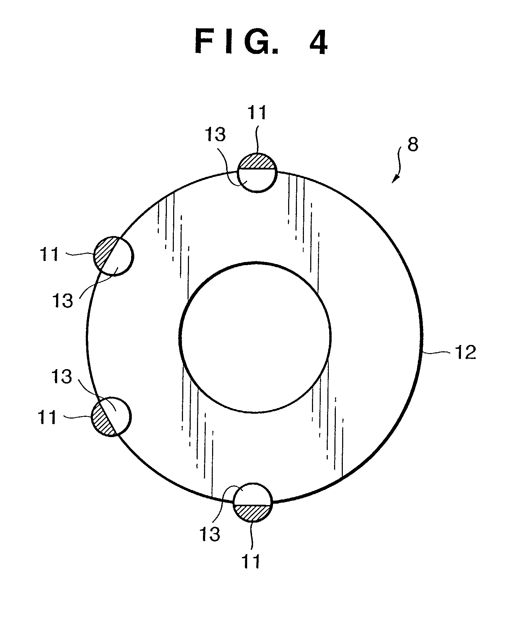

The shape of a boat serving as a holding tool will be described with reference to Figs. 3 and 4. Fig. 3 shows a wafer boat 7 applied to this embodiment. Four columns 11 symmetrically stand on a ring-shaped bottom plate 10. A ring-shaped top plate 12 is fixed on the upper ends of the columns 11. Each column 11 has a circular section. A number of wafer loading grooves 13 are formed in the vertical direction at a predetermined pitch in each column 11 on a side opposing the central axis of the wafer boat 7. Wafers are inserted into the grooves 13 of the four columns 11 and supported by a wafer boat 8 at the four groove portions.

The bottom plate and top plate need not have a ring shape but may have a circular plate shape. The sectional shape of each column need not always be circular. The columns, bottom plate, and top plate need not always be fixed. For example, the respective members may be assembled/disassembled.

### [First Embodiment]

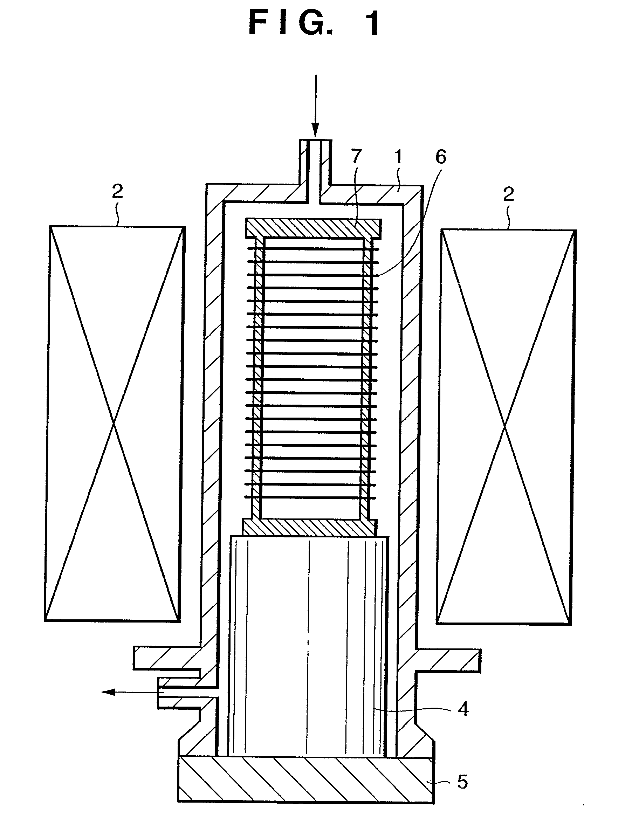

The first embodiment of an SOI wafer according to the present invention and an annealing method therefor will be described below with reference to Fig. 1. The shape of a holding tool 7 is the same as shown in Figs. 3 and 4. The SOI of this embodiment is not limited to silicon. As another material, e.g., SiGe (silicon germanium) may be used.

The same reference numerals as in the prior art shown in Fig. 2 denote the same parts in Fig. 1, and a description thereof will be omitted. The material of the boat serving as a holding tool is different from that in Fig. 2. The silicon boat 7 may be a highly pure heat-resistant member with a silicon coating film on its surface. From the viewpoint of durability, the silicon boat is preferably formed by processing a single-crystal silicon member or polysilicon member.

Instead of the silicon boat 7, a synthetic silicon carbide boat whose surface is made of highly pure synthetic silicon carbide synthesized by only CVD may be used. In this case, if the boat member contains sintered silicon carbide even in its internal member, the sintered silicon carbide can be a contamination source. Hence, the boat must not contain silicon carbide formed by sintering.

When such a member is used as a boat, contamination of an SOI wafer, which is conventionally caused by a metal impurity for sintered silicon carbide or silicon impregnated silicon carbide, can be effectively prevented. Hence, any HF defects can be prevented.

Annealing is performed in accordance with the following procedure. A furnace lid 5 is moved downward in advance. In this state, SOI wafers 6 are placed on the silicon boat 7. The furnace lid 5 is set in the state shown in Fig. 1 to load the SOI wafers 6 into the process chamber. The opening portion of a furnace tube 1 is closed. The furnace lid 5 is operated by a vertical moving mechanism (not shown). Hydrogen gas is introduced from the introduction tube into the furnace tube 1 to replace the interior in the process chamber with a hydrogen gas atmosphere. The interior in the process chamber is heated by a heater 2 to a predetermined process temperature. Annealing is performed. The predetermined process temperature is set to be lower than the melting point of single-crystal silicon.

After the elapse of a predetermined time, the temperature of the heater 2 is reduced. Then, nitrogen gas is introduced to replace the atmosphere. The furnace lid 5 is moved downward, and the SOI wafers 6 are unloaded. The process temperature, time, and the like are determined in accordance with the desired annealing effect.

In the present invention, the annealing temperature is not specifically defined. The present invention can exhibit a particularly excellent effect at a process temperature between 775°C at which nickel silicide forms and the melting point of silicon or less, between 966°C as the minimum eutectic temperature of nickel silicide and the melting point of silicon or less, or between 993°C as the melting point of nickel silicide and the melting point of silicon or less.

### (Example 1)

The HF defect density of an SOI wafer held by a silicon boat 7 and annealed in a reducing atmosphere at 1,050°C (present invention) was compared with that of a control, i.e., an SOI wafer annealed under the same conditions using a boat made of silicon carbide (prior art). To measure the HF defect density, each SOI wafer was dipped in hydrofluoric acid (HF) for 15 min. Then, the number of HF defects was measured by observing a predetermined range with an optical microscope. The measured number was divided by the observation area to obtain the HF defect density. Table 1 shows the results.

**[Table 1]**

| | Present invention | Prior art |
|---|---|---|
| HF defect density | 0.01 defects/cm² | 0.22 defects/cm² |

According to the technique of the present invention, the defect density on the SOI wafer could be reduced to about 1/20.

### (Example 2)

To confirm the reproducibility of the effect of the present invention, an SOI wafer was held by a silicon boat 7 and annealed in a reducing atmosphere, as in Example 1. A plurality of SOI wafers were prepared and individually annealed. The annealing temperature was set to fall within the range of 1,050°C to 1,100°C.

These wafers were evaluated as in Example 1 to obtain HF defect densities. The average value was 0.048 defects/cm². It was confirmed that even when the present invention was repeatedly practiced, an HF defect density of 0.05 defects/cm² or less could be achieved.

### [Second Embodiment]

### (Semiconductor Device Manufacturing Method)

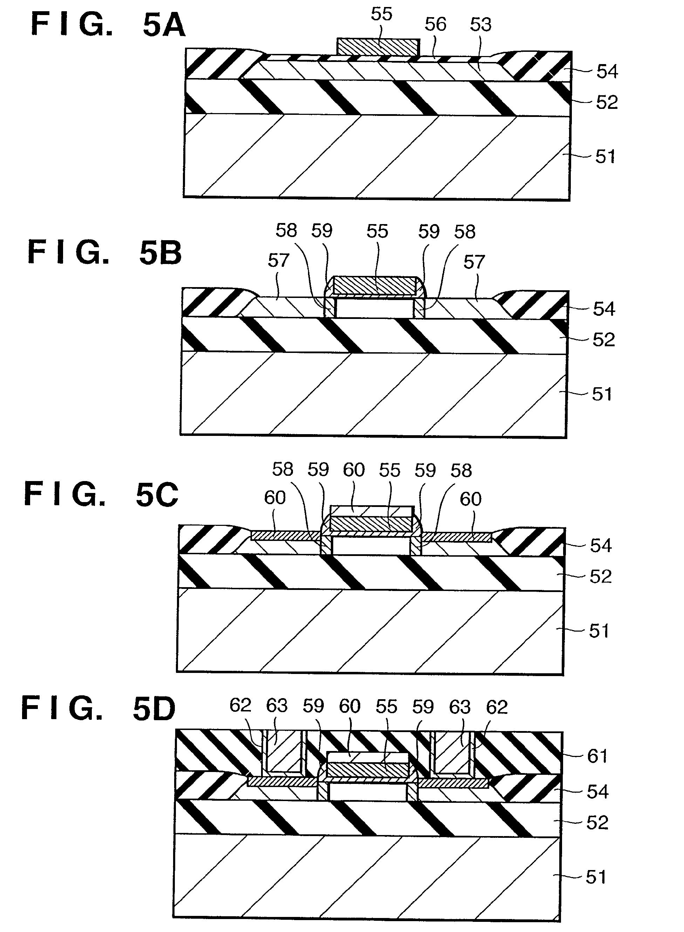

A semiconductor device using an SOI wafer according to the first embodiment and a method of manufacturing the device will be described below with reference to Figs. 5A to 5D as the second embodiment.

An SOI wafer annealed as in the above embodiment is prepared. The SOI wafer has a structure of SOI layer/ buried insulating film/base material. An SOI layer pattern 53 is formed in an active region, i.e., a region where a transistor should be formed, by patterning an SOI layer serving as a nonporous semiconductor layer on a buried insulating film 52 on a base material 51 into an island shape or oxidizing the SOI layer by LOCOS. In Figs. 5A to 5D, an element isolation region 54 made of an insulating material or the like is used.

A gate insulating film 56 is formed on the surface of the SOI layer 53. As the gate insulating film 56, silicon oxide, silicon nitride, silicon oxynitride, aluminum oxide, tantalum oxide, hafnium oxide, titanium oxide, scandium oxide, yttrium oxide, gadolinium oxide, lanthanum oxide, zirconium oxide, or a glass mixture thereof is used. The gate insulating film 56 can be formed by oxidizing the surface of the SOI layer 53 or depositing an insulating material on the surface of the SOI layer 53 by CVD or PVD (Physical Vapor Deposition).

A gate electrode 55 is formed on the gate insulating film 56. As the gate electrode 55, polysilicon doped with a p- or n-type impurity, a metal such as tungsten, molybdenum, titanium, tantalum, aluminum, or copper (including an alloy containing at least one of them), a metal silicide such as molybdenum silicide, tungsten silicide, or cobalt silicide, or a metal nitride such as titanium nitride, tungsten nitride, or tantalum nitride is used.

A plurality of layers of these materials may be stacked, like a polycide gate. Gate electrode formation using a process called salicide (self-align silicide) will be described here. However, the gate electrode may be formed by a method called a damascene gate process. With this process, the structure shown in Fig. 5A is obtained.

After the pattern of the gate electrode 55 is formed, an n-type impurity such as phosphorus, arsenic, or antimony or a p-type impurity such as boron is doped into the SOI layer 53 to form source and drain regions 58 which have a relatively low concentration and align with the side surfaces of the gate electrode 55. The impurity can be doped by ion implantation and annealing.

An insulating film is formed to cover the gate electrode 55 and etched back to form a side wall 59 on the side surface of the gate electrode 55. An impurity having the same conductivity type as described above is doped again to form source and drain regions 57 which have a relatively high concentration and align with the side wall 59. With this process, the structure shown in Fig. 5B is obtained.

The upper surface of the gate electrode and the upper surfaces of the source and drain regions are exposed. A silicide layer 60 is formed on the exposed surfaces. As a metal semiconductor compound that forms the silicide layer, a metal silicide is preferably used. More specifically, nickel silicide, titanium silicide, cobalt silicide, molybdenum silicide, or tungsten silicide is used. Such a silicide can be formed by depositing a metal to cover the upper surface of the gate electrode 55 and the upper surfaces of the source and drain regions 57, annealing and causing the metal to react with silicon in the source and drain regions 57, and then removing an unreacted portion of the metal using an etchant such as sulfuric acid. The surface of the silicide layer 60 may be also nitrided, as needed. With this process, the structure shown in Fig. 5C is obtained.

An insulating film 61 is formed to cover the upper surface of the gate electrode and the upper surfaces of the source and drain regions, which are converted into a silicide. As the insulating film 61, silicon oxide containing phosphorus and/or boron is preferably used.

The upper surface of the insulating film 61 is planarized as needed by etch-back or CMP. Then, contact holes are formed in the insulating film 61. When photolithography using a KrF excimer laser, ArF excimer laser, F₂ excimer laser, electron beam, or X-rays as a light source is used, a rectangular contact hole with a side shorter than 0.25 µm or a circular contact hole with a diameter shorter than 0.25 µm can be formed.

A conductive plug is formed in each contact hole. To form a conductive plug in each contact hole, at least one layer formed from a refractory metal, metal semiconductor compound, or refractory metal nitride is formed as a barrier metal layer 62. Then, a conductive material 63 such as tungsten or a tungsten alloy, aluminum or an aluminum alloy, or copper or a copper alloy is deposited using CVD, PVD, or plating. The conductive material on the upper surface of the insulating film may be removed by etch-back or CMP as needed.

Alternatively, after the surface of the silicide layer 60 in each of the source and drain regions 57 exposed from the contact holes is nitrided as needed, the contact holes may be filled with the conductive material. With this process, the structure (MOS thin-film transistor) shown in Fig. 5D is obtained. Thus, a semiconductor device such as a transistor can be manufactured using the SOI wafer of the present invention.

When the thickness and impurity concentration of the SOI layer are determined such that a depletion layer that spreads under the gate insulating film when a voltage is applied to the gate electrode reaches the upper surface of the buried insulating film, the transistor operates as a fully depleted transistor. When the thickness and impurity concentration of the SOI layer are determined such that the depletion layer does not reach the upper surface of the buried insulating film, the transistor operates as a partially depleted transistor.

As has been described above, according to the present invention, an SOI wafer for which the HF defect density is reduced by using annealing in a reducing atmosphere and an annealing method for the SOI wafer can be provided.

As many apparently widely different embodiments of the present invention can be made without departing from the spirit and scope thereof, it is to be understood that the invention is not limited to the specific embodiments thereof except as defined in the appended claims.

This invention relates to a method of manufacturing an SOI wafer having a low HF defect density using annealing in a reducing atmosphere. An SOI substrate is annealed in a reducing atmosphere at a temperature lower than the melting point of single-crystal silicon. To prevent any HF defects, a holding tool having a surface formed from silicon is used as a holding tool for holding the SOI substrate.

## Claims

1. An annealing method of annealing an SOI substrate in a reducing atmosphere, comprising the step of:
holding the SOI substrate by a holding portion having a surface formed from silicon and annealing the SOI substrate.

2. The method according to claim 1, wherein the annealing is executed at a temperature lower than a melting point of single-crystal silicon.

3. The method according to claim 1, wherein the annealing is executed at a temperature not less than 775°C.

4. The method according to claim 1, wherein the annealing is executed at a temperature not less than 966°C.

5. The method according to claim 1, wherein the annealing is executed at a temperature not less than 993°C.

6. An SOI substrate manufactured using an annealing method of any one of claims 1 to 5.

7. The substrate according to claim 6, wherein an HF defect density is not more than 0.05 defects/cm².

8. A semiconductor device manufacturing method, comprising the steps of:
annealing an SOI substrate using an annealing method of any one of claims 1 to 5; and
forming an active region for a transistor in a nonporous semiconductor layer of the SOI substrate.

9. A semiconductor device comprising:
an SOI substrate of claim 6 or 7; and
an active region for a transistor, which is formed in a nonporous semiconductor layer of the SOI substrate.

10. An annealing method of annealing an SOI substrate in a reducing atmosphere, comprising the step of:
holding the SOI substrate by a holding portion which contains no silicon carbide formed by sintering and has a surface formed from silicon carbide deposited by CVD and annealing the SOI substrate.

11. The method according to claim 10, wherein the annealing is executed at a temperature lower than a melting point of single-crystal silicon.

12. The method according to claim 10, wherein the annealing is executed at a temperature not less than 775°C.

13. The method according to claim 10, wherein the annealing is executed at a temperature not less than 966°C.

14. The method according to claim 10, wherein the annealing is executed at a temperature not less than 993°C.

15. An SOI substrate manufactured using an annealing method of any one of claims 10 to 14.

16. The substrate according to claim 15, wherein an HF defect density is not more than 0.05 defects/cm².

17. A semiconductor device manufacturing method, comprising the steps of:
annealing an SOI substrate using an annealing method of any one of claims 10 to 14; and
forming an active region for a transistor in a nonporous semiconductor layer of the SOI substrate.

18. A semiconductor device comprising:
an SOI substrate of claim 15 or 16; and
an active region for a transistor, which is formed in a nonporous semiconductor layer of the SOI substrate.
